# EUROPEAN PATENT SPECIFICATION

(11) **EP 2 924 143 B1**
(45) Date of publication and mention of the grant of the patent: **28.08.2024**
(21) Application number: 15161057.3
(22) Date of filing: 26.03.2015
(51) Int. Cl.: C23C 16/40, C23C 16/455, H01L 21/02, C07F 7/10

(54) **COMPOSITIONS AND METHODS FOR THE DEPOSITION OF SILICON OXIDE FILMS**
ZUSAMMENSETZUNGEN UND VERFAHREN ZUR ABSCHEIDUNG VON SILICIUMOXIDFILMEN
COMPOSITIONS ET PROCÉDÉS POUR LE DÉPÔT DE FILMS D'OXYDE DE SILICUM

(30) Priority: 26.03.2014 US 201461970602 P; 18.03.2015 US 201514661652
(43) Date of publication of application: 30.09.2015
(73) Proprietor: Versum Materials US, LLC, Tempe, AZ 85284 (US)
(72) Inventor: Mallikarjunan, Anupama, Macungie, PA 18062 (US); Chandra, Haripin, San Marcos, CA 92078 (US); Xiao, Manchao, San Diego, CA 92130 (US); Lei, Xinjian, Vista, CA 92081 (US); Cuthill, Kirk Scott, Vista, CA 92084 (US); O'Neill, Mark Leonard, Gilbert, AZ 85297 (US)
(74) Representative: Beck Greener LLP

(56) References cited:
- WO-A2-2012/167060
- GB-A- 1 110 846
- JP-A- 2010 275 602
- US-A- 3 305 525
- US-A- 3 462 386
- US-A1- 2010 291 321
- US-A1- 2011 215 445
- B B BURTON ET AL: "SiO 2 Atomic Layer Deposition Using Tris(dimethylamino)silane and Hydrogen Peroxide Studied by in Situ Transmission FTIR Spectroscopy", JOURNAL OF PHYSICAL CHEMISTRY C, vol. 113, no. 19, 17 April 2009 (2009-04-17), pages 8249 - 8257, XP055066731, ISSN: 1932-7447, DOI: 10.1021/jp806638e

## Description

### BACKGROUND OF THE INVENTION

Described herein is a composition and method for the formation of a silicon and oxide containing film. More specifically, described herein is a composition and method for formation of a stoichiometric or a non-stoichiometric silicon oxide film or material at one or more deposition temperatures of about 300°C or less, or ranging from about 25°C to about 300°C.

Atomic Layer Deposition (ALD) and Plasma Enhanced Atomic Layer Deposition (PEALD) are processes used to deposit silicon oxide conformal film at low temperature (<500°C). In both ALD and PEALD processes, the precursor and reactive gas (such as oxygen or ozone) are separately pulsed in certain number of cycles to form a monolayer of silicon oxide at each cycle. However, silicon oxide deposited at low temperatures using these processes may contain levels of impurities such as, without limitation, nitrogen (N) which may detrimental in certain semiconductor applications. To remedy this, one possible solution is to increase the deposition temperature to 500°C or greater. However, at these higher temperatures, conventional precursors employed by semiconductor industries tend to self-react, thermally decompose, and deposit in a chemical vapor deposition (CVD) mode rather than an ALD mode. The CVD mode deposition has reduced conformality compared to ALD deposition, especially for high aspect ratio structures which are needed in many semiconductor applications. In addition, the CVD mode deposition has less control of film or material thickness than the ALD mode deposition.

The reference article entitled "Some New Alkylaminosilanes", Abel, E.W. et al., J. Chem. Soc., (1961), Vol. 26, pp. 1528-1530 describes the preparation of various aminosilane compounds such as Me₃SiNHBu-iso, Me₃SiNHBu-sec, Me₃SiN(Pr-iso)₂, and Me₃SiN(Bu-sec)₂ wherein Me = methyl, Bu-sec = sec-butyl, and Pr-iso = isopropyl from the direct interaction of trimethylchlorosilane (Me₃SiCl) and the appropriate amine.

The reference article entitled "SiO2 Atomic Layer Deposition Using Tris(dimethylamino)silane and Hydrogen Peroxide Studied by in Situ Transmission FTIR Spectroscopy", Burton, B. B., et al., The Journal of Physical Chemistry (2009), Vol. 113, pp. 8249-57 describes the atomic layer deposition (ALD) of silicon dioxide (SiO₂) using a variety of silicon precursors with H₂O₂ as the oxidant. The silicon precursors were (N,N-dimethylamino)trimethylsilane) (CH₃)₃SiN(CH₃)₂, vinyltrimethoxysilane CH₂CHSi(OCH₃)₃, trivinylmethoxysilane (CH₂CH)₃SiOCH₃, tetrakis(dimethylamino)silane Si(N(CH₃)₂)₄, and tris(dimethylamino)silane (TDMAS) SiH(N(CH₃)₂)₃. TDMAS was determined to be the most effective of these precursors. However, additional studies determined that SiH* surface species from TDMAS were difficult to remove using only H₂O. Subsequent studies utilized TDMAS and H₂O₂ as the oxidant and explored SiO₂ ALD in the temperature range of 150-550°C. The exposures required for the TDMAS and H₂O₂ surface reactions to reach completion were monitored using in situ FTIR spectroscopy. The FTIR vibrational spectra following the TDMAS exposures showed a loss of absorbance for O-H stretching vibrations and a gain of absorbance for C-Hx and Si-H stretching vibrations. The FTIR vibrational spectra following the H₂O₂ exposures displayed a loss of absorbance for C-Hx and Si-H stretching vibrations and an increase of absorbance for the O-H stretching vibrations. The SiH* surface species were completely removed only at temperatures >450°C. The bulk vibrational modes of SiO₂ were observed between 1000-1250 cm⁻¹ and grew progressively with number of TDMAS and H₂O₂ reaction cycles. Transmission electron microscopy (TEM) was performed after 50 TDMAS and H₂O₂ reaction cycles on ZrO₂ nanoparticles at temperatures between 150-550°C. The film thickness determined by TEM at each temperature was used to obtain the SiO₂ ALD growth rate. The growth per cycle varied from 0.8 Å/cycle at 150°C to 1.8 Å/cycle at 550 °C and was correlated with the removal of the SiH* surface species. SiO₂ ALD using TDMAS and H₂O₂ should be valuable for SiO2 ALD at temperatures >450 °C.

JP2010275602 and JP2010225663 disclose the use of a raw material to form a Si containing thin film, such as silicon oxide, by a chemical vapor deposition (CVD) process at a temperature range of from 300-500⁰C. The raw material is an organic silicon compound, represented by formula: (a) HSi(CH₃)(R¹)(NR²R³), wherein R¹ represents NR⁴R⁵ or a 1C-5C alkyl group; R² and R⁴ each represent a 1C-5C alkyl group or hydrogen atom; and R³ and R⁵ each represent a 1C-5C alkyl group; or (b) HSiCl(NR¹R²)(NR³R⁴), wherein R¹ and R³ independently represent an alkyl group having 1 to 4 carbon atoms, or a hydrogen atom; and R² and R⁴ independently represent an alkyl group having 1 to 4 carbon atoms. The organic silicon compounds contained H-Si bonds.

U.S. Pat. No. 5,424,095 describes a method to reduce the rate of coke formation during the industrial pyrolysis of hydrocarbons. The interior surface of a reactor is coated with a uniform layer of a ceramic material, the layer being deposited by thermal decomposition of a non-alkoxylated organosilicon precursor in the vapor phase, in a steam containing gas atmosphere in order to form oxide ceramics.

U. S. Publ. No. 2010/0291321 describes a PECVD process for forming a high-quality Si carbonitride barrier dielectric film between a dielectric film and a metal interconnect of an integrated circuit substrate, comprising the steps of: providing an integrated circuit substrate having a dielectric film or a metal interconnect; contacting the substrate with a barrier dielectric film precursor comprising: RₓR_{y}(NRR')_{z}Si wherein R, R', R and R' are each individually selected from H, linear or branched saturated or unsaturated alkyl, or aromatic group; wherein x+y+z = 4; z = 1 to 3; but R, R' cannot both be H; and where z = 1 or 2 then each of x and y are at least 1; forming the Si carbonitride barrier dielectric film with C/Si ratio>0.8 and a N/Si ratio >0.2 on the integrated circuit substrate.

U. S. Publ. No. 2013/0295779 A describes an atomic layer deposition (ALD) process for forming a silicon oxide film at a deposition temperature > 500°C using silicon precursors having the following formula:

I. R¹R² ₘSi(NR³R⁴)ₙXₚ

wherein R', R², and R³ are each independently selected from hydrogen, a linear or branched C₁ to C₁₀ alkyl group, and a C₆ to C₁₀ aryl group; R⁴ is selected from, a linear or branched C₁ to C₁₀ alkyl group, and a C₆ to C₁₀ aryl group, a C₃ to C₁₀ alkylsilyl group; wherein R³ and R⁴ are linked to form a cyclic ring structure or R³ and R⁴ are not linked to form a cyclic ring structure; X is a halide selected from the group consisting of CI, Br and I; m is 0 to 3; n is 0 to 2; and p is 0 to 2 and m+n+p = 3; and

II. R¹R² ₘSi(OR³)ₙ(OR⁴)_{q}Xₚ

wherein R¹ and R² are each independently selected from hydrogen, a linear or branched C₁ to C₁₀ alkyl group, and a C₆ to C₁₀ aryl group; R³ and R⁴ are each independently selected from a linear or branched C₁ to C₁₀ alkyl group, and a C₆ to C₁₀ aryl group; wherein R³ and R⁴ are linked to form a cyclic ring structure or R³ and R⁴ are not linked to form a cyclic ring structure; X is a halide atom selected from the group consisting of CI, Br and I; m is 0 to 3; n is 0 to 2; q is 0 to 2 and p is 0 to 2 and m+n+q+p = 3.

U.S. Pat. No. 7,084,076 discloses a halogenated siloxane such as hexachlorodisiloxane (HCDSO) that is used in conjunction with pyridine as a catalyst for ALD deposition below 500⁰C to form silicon dioxide.

U.S. Pat. No. 6,992,019 discloses a method for catalyst-assisted atomic layer deposition (ALD) to form a silicon dioxide layer having superior properties on a semiconductor substrate by using a first reactant component consisting of a silicon compound having at least two silicon atoms, or using a tertiary aliphatic amine as the catalyst component, or both in combination, together with related purging methods and sequencing. The precursor used is hexachlorodisilane. The deposition temperature is between 25 -150⁰C.

WO 2012/167060 describes a composition for depositing a carbon-doped silicon containing film comprising: comprising at least one compound selected from the group consisting of:
(i) an organoaminoaikylsiiane having a formula of R⁵Si(NR³R⁴)ₓH₃₋ₓ wherein x=1, 2, 3;
(ii) an organoalkoxyalkylsilane having a formula of R⁶Si(OR⁷)ₓH₃₋ₓ wherein x=1, 2, 3;
(iii) an organoaminosilane having a formula of R⁸N(SiR⁹(NR¹⁰R¹¹)H)₂;
(iv) an organoaminosilane having a formula of R⁸N(SiR⁹LH)₂ and combinations thereof
wherein R³, R⁴, and R⁷ are each independently selected from the group consisting of a C₁ to C₁₀ linear or branched alkyl group, a C₃ to C₁₀ cyclic alkyl group, a linear or branched C₂ to C₁₀ alkenyl group, a linear or branched C₂ to C₁₀ alkynyl group, a C₅ to C₁₀ aromatic group, and a C₃ to C₁₀ saturated or unsaturated heterocyclic group; R₅ and R⁶ are each independently selected from the group consisting of a C₁ to C₁₀ linear or branched alkyl group, a C₃ to C₁₀ cyclic alkyl group, a linear or branched C₂ to C₁₀ alkenyl group, a linear or branched C₂ to C₁₀ alkynyl group, a C₅ to C₁₀ aromatic group, and a C₃ to C₁₀ saturated or unsaturated heterocyclic group and a halide atom; R₈ and R₉ are each independently selected from the group consisting of hydrogen, C₁ to C₁₀ linear or branched alkyl, a C₃ to C₁₀ cyclic alkyl group, a linear or branched C₂ to C₁₀ alkenyl group, a linear or branched C₂ to C₁₀ alkynyl group, a C₅ to C₁₀ aromatic group, and a C₃ to C₁₀ saturated or unsaturated heterocyclic group; and R¹⁰ and R¹¹ are each independently selected from the group consisting of a C₁ to C₁₀ linear or branched alkyl group, a C₃ to C₁₀ cyclic alkyl group, a linear or branched C₂ to C₁₀ alkenyl group, a linear or branched C₂ to C₁₀ alkynyl group, a C₅ to C₁₀ aromatic group, and a C₃ to C₁₀ saturated or unsaturated heterocyclic group; wherein R³ and R⁴ can form a cyclic ring or an alkyl-substituted cyclic ring; and wherein R¹⁰ and R¹¹ can form a cyclic ring or an alkyl-substituted cyclic ring; and L=CI, Br, I.

U. S. Publ. No. 2010/0291321 describes a process for forming a silicon carbonitride barrier dielectric film between a dielectric film and a metal interconnect of an integrated circuit substrate, comprising the steps of: providing the integrated circuit substrate having a dielectric film; contacting the substrate with a barrier dielectric film precursor comprising: RₓR'_{y}(NR"R‴)_{z}Si; wherein R, R', R" and R‴ are each individually selected from hydrogen, linear or branched saturated or unsaturated alkyl, or aromatic; wherein x+y+z=4; z=1-3; but R, R' cannot both be hydrogen; and forming the silicon carbonitride barrier dielectric film with C/Si ratio > 0.8 and a N/Si ratio >0.2 on the integrated circuit substrate.

Thus, there is still a need to develop a process for forming a silicon oxide film having at least one or more of the following attributes: a density of about 2.1g/cc or greater, low chemical impurity, and/or high conformality in a plasma enhanced atomic layer deposition (ALD) process or a plasma enhanced ALD-like process using cheaper, reactive, and more stable organoaminosilanes. In addition, there is a need to develop precursors that can provide tunable films for example, ranging from silicon oxide to carbon doped silicon oxide.

### BRIEF SUMMARY OF THE INVENTION

Described herein is a process for the deposition of a stoichiometric or nonstoichiometric silicon oxide material or film, such as, without limitation, a silicon oxide, a carbon doped silicon oxide, a silicon oxynitride film, or a carbon doped silicon oxynitride film at relatively low temperatures, e.g., at one or more temperatures of 300⁰C or lower, in a plasma enhanced ALD, plasma enhanced cyclic chemical vapor deposition (PECCVD), a plasma enhanced ALD-like process, or an ALD process with oxygen reactant source.

In one aspect, there is provided a method to deposit a film comprising silicon and oxide onto a substrate which comprises the steps of:
a) providing a substrate in a reactor;
b) introducing into the reactor at least one silicon precursor selected from the group consisting of bis(sec-butylamino)methylsilane, bis(isobutylamino)methylsilane, bis(cyclohexylamino)methylsilane and combinations thereof;
c) purging the reactor with a purge gas;
d) introducing an oxygen-containing source into the reactor; and
e) purging the reactor with the purge gas; and
wherein the steps b through e are repeated until a desired thickness of film is deposited; and wherein the method is conducted at one or more temperatures ranging from about 25°C to 300°C.

In this or other embodiments, the oxygen-containing source is a source selected from the group consisting of an oxygen plasma, a water vapor, water vapor plasma, nitrogen oxide (e.g., N₂O, NO, NO₂) plasma with or without inert gas, a carbon oxide (e.g., CO₂, CO) plasma and combinations thereof. In certain embodiments, the oxygen source further comprises an inert gas. In these embodiments, the inert gas is selected from the group consisting of argon, helium, nitrogen, hydrogen, and combinations thereof. In an alternative embodiment, the oxygen source does not comprise an inert gas. In yet another embodiment, the oxygen-containing source comprises nitrogen which reacts with the reagents under plasma conditions to provide a silicon oxynitride film.

In one or more embodiments described above, the purge gas is selected from the group consisting of nitrogen, helium and argon. In another aspect, there is provided a method to deposit a film selected from a silicon oxide film and a carbon doped silicon oxide film onto a substrate comprising the steps of:
a. providing the substrate in a reactor;
b. introducing into the reactor at least one silicon precursor selected from the group consisting of bis(sec-butylamino)methylsilane, bis(isobutylamino)methylsilane, bis(cyclohexylamino)methylsilane and combinations thereof;
c. purging the reactor with a purge gas;
d. introducing an oxygen-containing source into the reactor; and
e. purging reactor with purge gas; and
wherein steps b through e are repeated until a desired thickness of film is deposited; and wherein the method is conducted at one or more temperatures ranging from about 25°C to about 300°C.

In one or more embodiments described above, the oxygen-containing source is preferably an oxygen-containing plasma source selected from the group consisting of oxygen plasma with or without inert gas, water vapor plasma with or without inert gas, nitrogen oxides (N₂O, NO, NO₂) plasma with or without inert gas, carbon oxides (CO₂, CO) plasma with or without inert gas, and combinations thereof. In certain embodiments, the oxygen-containing plasma source further comprises an inert gas. In these embodiments, the inert gas is preferably selected from the group consisting of argon, helium, nitrogen, hydrogen, or combinations thereof. In an alternative embodiment, the oxygen-containing plasma source does not comprise an inert gas.

In yet another aspect, there is provided a composition for depositing a film selected from a silicon oxide or a carbon doped silicon oxide film using a vapor deposition process, the composition comprising: a compound selected from the group consisting of bis(sec-butylamino)methylsilane, bis(isobutylamino)methylsilane, bis(cyclohexylamino)methylsilane and combinations thereof.

In one embodiment of the composition described above, the composition comprises the at least one silicon precursor wherein the precursor is substantially free of at least one selected from the amines, halides, higher molecular weight species, and trace metals.

Features described in connection with one aspect of the invention may be used with any other aspect of the invention.

### BRIEF DESCRIPTION OF SEVERAL VIEWS OF THE DRAWINGS

Figure 1 shows the Fourier Transform Infrared (FTIR) spectrum of the film deposited as described in Example 6 which shows no evidence of C-H or Si-CH₃ bonding.
Figure 2 provides current versus electric field for silicon oxide films deposited as described in Example 6 at 100°C with dimethylaminotrimethylsilane (DMATMS) vs. thermal oxide (not according to the invention).
Figure 3 illustrates the growth per cycle behavior for films deposited using the following precursors bis(diethylamino)silane (BDEAS) (not according to the invention), bis(sec-butylamino)methylsilane (BSBAMS), and bis(diethylamino)methylsilane (BDEAMS) (not according to the invention) and the process conditions provided in Table 11.

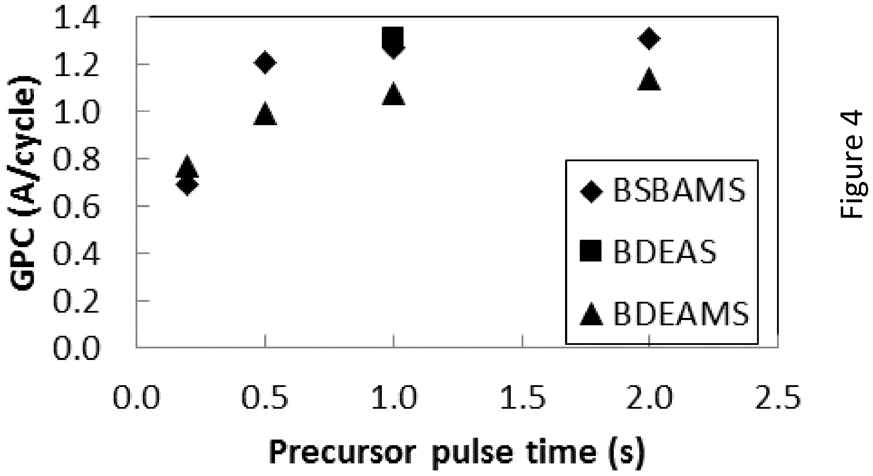

Figure 4 shows the saturation behavior for BSBAMS and BDEAMS (not according to the invention) deposited films according to the process conditions provided in Table 10 at a temperature of 100° C with various precursor pulse times ranging from 0.2 to 2 seconds (s).

### DETAILED DESCRIPTION OF THE INVENTION

Described herein are methods related to the formation of a stoichiometric or nonstoichiometric film or material comprising silicon and oxide, such as without limitation a silicon oxide, a carbon-doped silicon oxide film, a silicon oxynitride, a carbon-doped silicon oxynitride films or combinations thereof with one or more temperatures, of about 300°C or less, or from about 25°C to about 300°C. The films described herein are deposited in a deposition process such as an atomic layer deposition (ALD) or in an ALD-like process, such as without limitation a plasma enhanced ALD or a plasma enhanced cyclic chemical vapor deposition process (CCVD). The low temperature deposition (e.g., one or more deposition temperatures ranging from about ambient temperature to 300°C) methods described herein provide films or materials that preferably exhibit at least one or more of the following advantages: a density of about 2.1g/cc or greater, low chemical impurity, high conformality in a plasma enhanced atomic layer deposition (ALD) process or a plasma enhanced ALD-like process, an ability to adjust carbon content in the resulting film; and/or films having a etching rate of 5 Angstroms per second (A/sec) or less when measured in dilute HF. For carbon-doped silicon oxide films, greater than 1% carbon is desired to tune the etch rate to values below 2 Ǻ/sec in addition to other characteristics, such as, without limitation, a density of about 1.8g/cc or greater or about 2.0g/cc or greater.

In one embodiment of the method described herein, the method is conducted via an ALD process that uses an oxygen-containing source which comprises a plasma wherein the plasma can further comprise an inert gas such as one or more of the following: an oxygen plasma with or without inert gas, a water vapor plasma with or without inert gas, a nitrogen oxide (e.g., N₂O, NO, NO₂) plasma with or without inert gas, a carbon oxide (e.g., CO₂, CO) plasma with or without inert gas, and combinations thereof. In this embodiment, the method for depositing a silicon oxide film on at least one surface of a substrate comprises the following steps:
a. providing a substrate in a reactor;
b. introducing into the reactor at least one silicon precursor selected from the group consisting of bis(sec-butylamino)methylsilane, bis(isobutylamino)methylsilane, bis(cyclohexylamino)methylsilane and combinations thereof;
c. purging the reactor with purge gas;
d. introducing oxygen-containing source comprising a plasma into the reactor; and
e. purging the reactor with a purge gas.

In the method described above, steps b through e are repeated until a desired thickness of film is deposited on the substrate. The oxygen-containing plasma source can be generated in situ or, alternatively, remotely. In one particular embodiment, the oxygen-containing source comprises oxygen and is flowing, or introduced during method steps b through d, along with other reagents such as, without limitation, the at least one silicon precursor and optionally an inert gas.

In another embodiment of the method described herein, the method is used to deposit a carbon-doped silicon oxide film on at least one surface of a substrate comprising the steps of:
a. providing a substrate in a reactor;
b. introducing into the reactor at least one silicon precursor selected from the group consisting of bis(sec-butylamino)methylsilane, bis(isobutylamino)methylsilane, bis(cyclohexylamino)methylsilane and combinations thereof;
c. purging the reactor with purge gas;
d. introducing an oxygen-containing source into the reactor;
e. purging reactor with purge gas;
where steps b through e are repeated until a desired thickness of carbon doped silicon oxide is deposited; and wherein the process is conducted at one or more temperatures of about 300°C or less. In this or other embodiments, the oxygen-containing source is preferably selected from the group consisting of ozone, oxygen plasma with or without inert gas, water vapor plasma with or without inert gas, nitrogen oxides (N₂O, NO, NO₂) plasma with or without inert gas, carbon oxides (CO₂, CO) plasma with or without inert gas, and combinations thereof. In one particular embodiment, the oxygen-containing source comprises a carbon dioxide plasma. In this or other embodiments, the oxygen-containing source comprises an inert gas which is selected from the group consisting of argon, helium, nitrogen, hydrogen, and combinations thereof. In embodiments wherein the oxygen-containing source comprises a plasma, the plasma can be generated in situ in the reactor or can be generated remotely and then introduced into the reactor. In one particular embodiment, the oxygen-containing source comprises oxygen and is flowing, or introduced during method steps b through d, along with other reagents such as without limitation, the at least one silicon precursor and optionally an inert gas.

The at least one silicon containing precursor described herein is selected from the group consisting of bis(sec-butylamino)methylsilane, bis(isobutylamino)methylsilane, bis(cyclohexylamino)methylsilane and combinations thereof.

Exemplary precursors are listed in the following Table 4:

**Table 4. Bisaminoalkylsilane compounds**

| | |
|---|---|
| 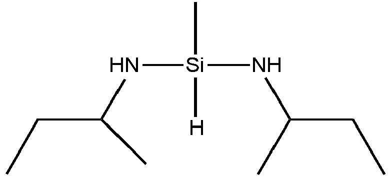 Bis(sec-butylamino)methylsilane | |
| 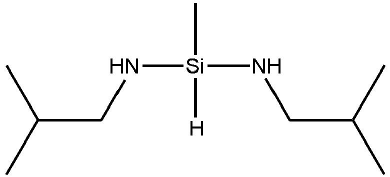 Bis(iso-butylamino)methylsilane | 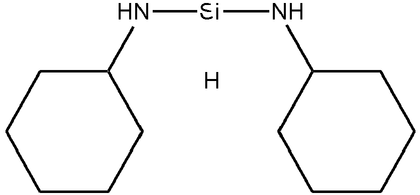 Bis(cyclohexylamino)methylsilane |

Throughout the description, the term "alkyl" denotes a linear or branched functional group having from 1 to 6 carbon atoms. Exemplary linear alkyl groups include, but are not limited to, methyl, ethyl, propyl, butyl, pentyl, and hexyl groups. Exemplary branched alkyl groups include, but are not limited to, iso-propyl, iso-butyl, sec-butyl, tert-butyl, isopentyl, tert-pentyl, iso-hexyl, and neo-hexyl. In certain embodiments, the alkyl group may have one or more functional groups attached thereto such as, but not limited to, an alkoxy group, a dialkylamino group or combinations thereof. In other embodiments, the alkyl group does not have one or more functional groups attached thereto. The alkyl group may be saturated or, alternatively, unsaturated.

Throughout the description, the term "cyclic alkyl" denotes a cyclic functional group having from 4 to 10 carbon atoms. Exemplary cyclic alkyl groups include, but are not limited to, cyclobutyl, cyclopentyl, cyclohexyl, and cyclooctyl groups.

Throughout the description, the term "alkenyl group" denotes a group which has one or more carbon-carbon double bonds and has from 2 to 10 or from 2 to 6 carbon atoms.

Throughout the description, the term "alkynyl group" denotes a group which has one or more carbon-carbon triple bonds and has from 3 to 10 or from 2 to 10 or from 2 to 6 carbon atoms.

Throughout the description, the term "aryl" denotes an optionally functionalised aromatic cyclic functional group having from 4 to 10 carbon atoms, from 5 to 10 carbon atoms, or from 6 to 10 carbon atoms and optionally one or more heteroatoms (e.g. oxygen, nitrogen). The term "aryl" includes aralkyl groups. Exemplary aryl groups include, but are not limited to, phenyl, benzyl, chlorobenzyl, tolyl, o-xylyl, 1,2,3-triazolyl, pyrrolyl, and furanyl.

Throughout the description, the term "amino" denotes an organoamino group having from 1 to 10 carbon atoms derived from an organoamine with formula of HNR²R³. Exemplary amino groups include, but are not limited to, secondary amino groups derived from secondary amines such as dimethylamino (Me₂N-), diethylamino (Et₂N-), di-iso-propylamino (ⁱPr₂N-); primary amino groups derived from primary amines such as methylamino (MeNH-), ethylamino (EtNH-), iso-propylamino (ⁱPrNH-), sec-butylamino (^{s}BuNH-), tert-butylamino(^{t}BuNH-).

In certain embodiments, the silicon oxide or carbon doped silicon oxide films deposited using the methods described herein are formed in the presence of an oxygen-containing source comprising at least one of ozone, water (H₂O) (e.g., deionized water, purifier water, and/or distilled water), oxygen (O₂), oxygen plasma, NO, N₂O, NO₂, carbon monoxide (CO), carbon dioxide (CO₂) and combinations thereof. The oxygen-containing source may be passed through a plasma generator in situ or remotely to provide an oxygen-containing plasma source such as an oxygen plasma, a plasma comprising oxygen and argon, a plasma comprising oxygen and helium, an ozone plasma, a water plasma, a nitrous oxide plasma, or a carbon dioxide plasma. In certain embodiments, the oxygen-containing plasma source comprises an oxygen source gas that is introduced into the reactor at a flow rate ranging from about 1 to about 2000 standard cubic centimeters per minute (sccm) or from about 1 to about 1000 sccm. The oxygen-containing plasma source can be introduced for a time that ranges from about 0.1 to about 100 seconds. In one particular embodiment, the oxygen-containing plasma source comprises water having a temperature of 10°C or greater. In embodiments wherein the film is deposited by a PEALD or a plasma enhanced cyclic CVD process, the precursor pulse can have a pulse duration that is greater than 0.01 seconds, and the oxygen-containing plasma source can have a pulse duration that is less than 0.01 seconds.

The deposition methods disclosed herein may involve one or more purge gases. The purge gas, which is used to purge away unconsumed reactants and/or reaction byproducts, is an inert gas that does not react with the precursors. Exemplary purge gases include, but are not limited to, argon (Ar), nitrogen (N₂), helium (He), neon (Ne), hydrogen (H₂), and mixtures thereof. In certain embodiments, a purge gas such as Ar is supplied into the reactor at a flow rate ranging from about 10 to about 2000 sccm for about 0.1 to 1000 seconds, thereby purging the unreacted material and any byproduct that may remain in the reactor.

The times for supplying the precursors, oxygen source, and/or other precursors, source gases, and/or reagents may be changed to change the stoichiometric composition of the resulting dielectric film.

Energy is applied to at least one of the silicon precursor, oxygen containing source, or combination thereof to induce reaction and to form the dielectric film or coating on the substrate. Such energy can be provided by, but is not limited to, thermal, plasma, pulsed plasma, helicon plasma, high density plasma, inductively coupled plasma, X-ray, e-beam, photon, and remote plasma methods, and combinations thereof. In certain embodiments, a secondary RF frequency source can be used to modify the plasma characteristics at the substrate surface. In embodiments wherein the deposition involves plasma, the plasma-generated process may comprise a direct plasma-generated process in which plasma is directly generated in the reactor, or alternatively, a remote plasma-generated process in which plasma is generated outside the reactor and supplied into the reactor.

The at least one silicon precursor may be delivered to the reaction chamber such as a plasma enhanced cyclic CVD or PEALD reactor or a batch furnace type reactor in a variety of ways. In one embodiment, a liquid delivery system may be utilized. In an alternative embodiment, a combined liquid delivery and flash vaporization process unit may be employed, such as, for example, the turbo vaporizer manufactured by MSP Corporation of Shoreview, MN, to enable low volatility materials to be volumetrically delivered, which leads to reproducible transport and deposition without thermal decomposition of the precursor. In liquid delivery formulations, the precursors described herein may be delivered in neat liquid form, or alternatively, may be employed in solvent formulations or compositions comprising same. Thus, in certain embodiments the precursor formulations may include solvent component(s) of such character as may be desirable and advantageous in a given end use application to form a film on a substrate.

For those embodiments wherein the at least one silicon precursor described herein is used in a composition comprising a solvent and at least one silicon precursor described herein, the solvent or mixture thereof selected preferably does not react with the silicon precursor. The amount of solvent by weight percentage in the composition preferably ranges from 0.5% by weight to 99.5% or from 10% by weight to 75%. In this or other embodiments, preferably the solvent has a boiling point (b.p.) similar to the b.p. of the at least one silicon precursor or the difference between the b.p. of the solvent and the b.p. of the at least one silicon precursor is 40°C or less, 30°C or less, or 20°C or less, or 10°C or less. Alternatively, the difference between the boiling points can range from any one or more of the following end-points: 0, 10, 20, 30, or 40°C. Examples of suitable ranges of b.p. difference include, without limitation, 0 to 40°C, 20° to 30°C, or 10° to 30°C. Examples of suitable solvents in the compositions include, but are not limited to, an ether (such as 1,4-dioxane, dibutyl ether), a tertiary amine (such as pyridine, 1-methylpiperidine, 1-ethylpiperidine, N,N'-Dimethylpiperazine, N,N,N',N'-Tetramethylethylenediamine), a nitrile (such as benzonitrile), an alkane (such as octane, nonane, dodecane, ethylcyclohexane), an aromatic hydrocarbon (such as toluene, mesitylene), a tertiary aminoether (such as bis(2-dimethylaminoethyl) ether), or mixtures thereof.

As previously mentioned, the purity level of the at least one silicon precursor is preferably sufficiently high enough to be acceptable for reliable semiconductor manufacturing. In certain embodiments, the at least one silicon precursor described herein comprises less than 2% by weight, or less than 1% by weight, or less than 0.5% by weight of one or more of the following impurities: free amines, free halides or halogen ions, and higher molecular weight species. Higher purity levels of the silicon precursor described herein can be obtained through one or more of the following processes: purification, adsorption, and/or distillation.

In one embodiment of the method described herein, a plasma enhanced cyclic deposition process such as a PEALD-like process or PEALD may be used wherein the deposition is conducted using the at least one silicon precursor and an oxygen source. The PEALD-like process is defined as a plasma enhanced cyclic CVD process but which still provides highly conformal silicon oxide films.

In certain embodiments, the gas lines connecting the precursor canisters to the reaction chamber are heated to one or more temperatures depending upon the process requirements and the container of the at least one silicon precursor is kept at one or more temperatures for bubbling. In other embodiments, a solution comprising the at least one silicon precursor is injected into a vaporizer kept at one or more temperatures for direct liquid injection.

A flow of argon and/or other gas may be employed as a carrier gas to help deliver the vapor of the at least one silicon precursor to the reaction chamber during the precursor pulsing. In certain embodiments, the reaction chamber process pressure is about 50 mTorr (7 Pa) to 10 Torr (1.3 kPa). In other embodiments, the reaction chamber process pressure can be up to 760 Torr (100 kPa).

In a typical PEALD or PEALD-like process such as a PECCVD process, the substrate such as a silicon oxide substrate is heated on a heater stage in a reaction chamber that is exposed to the silicon precursor initially to allow the complex to chemically adsorb onto the surface of the substrate.

A purge gas such as argon purges away unabsorbed excess complex from the process chamber. After sufficient purging, an oxygen source may be introduced into reaction chamber to react with the absorbed surface followed by another gas purge to remove reaction by-products from the chamber. The process cycle can be repeated to achieve the desired film thickness. In some cases, pumping can replace a purge with inert gas or both can be employed to remove unreacted silicon precursors.

In this or other embodiments, it is understood that the steps of the methods described herein may be performed in a variety of orders, may be performed sequentially, may be performed concurrently (e.g., during at least a portion of another step), or may be performed in any combination. The respective step of supplying the precursors and the oxygen source gases may be performed by varying the duration of the time for supplying them to change the stoichiometric composition of the resulting dielectric film. Also, purge times after precursor or oxidant steps can be minimized to < 0. 1 s so that throughput is improved.

One particular embodiment of the method described herein to deposit a high quality silicon oxide film on a substrate comprises the following steps:
a. providing a substrate in a reactor;
b. introducing into the reactor at least one silicon precursor selected from the group consisting of bis(sec-butylamino)methylsilane, bis(isobutylamino)methylsilane, bis(cyclohexylamino)methylsilane and combinations thereof;
c. purging reactor with purge gas to remove at least a portion of the unsorbed precursors;
d. introducing an oxygen-containing plasma source into the reactor and
e. purging reactor with purge gas to remove at least a portion of the unreacted oxygen source
wherein steps b through e are repeated until a desired thickness of the silicon oxide film is deposited.

Yet another method disclosed herein forms a carbon doped silicon oxide film using a bisaminoalkylsilane compound and an oxygen source.

A still further exemplary process is described as follows:
a. Providing a substrate in a reactor
b. Contacting vapors generated from a bisaminoalkylsilane compound selected from the group consisting of bis(sec-butylamino)methylsilane, bis(isobutylamino)methylsilane, bis(cyclohexylamino)methylsilane and combinations thereof with or without co-flowing an oxygen source to chemically sorb the precursors on the heated substrate;
c. Purging away any unsorbed precursors;
d. Introducing an oxygen source on the heated substrate to react with the sorbed precursors; and,
e. Purging away any unreacted oxygen source;
wherein steps b through e are repeated until a desired thickness is achieved.

Various commercial ALD reactors such as single wafer, semi-batch, batch furnace or roll to roll reactor can be employed for depositing the solid silicon oxide or carbon doped silicon oxide.

Process temperature for the method described herein preferably use one or more of the following temperatures as endpoints: 0, 25, 50, 75, 100, 125, 150, 175, 200, 225, 250, 275, and 300°C. Exemplary temperature ranges include, but are not limited to the following: from about 0°C to about 300°C; or from about 25°C to about 300°C; or from about 50⁰C to about 290⁰C; or from about 25°C to about 250°C, or from about 25°C to about 200°C.

As mentioned previously, the method described herein may be used to deposit a silicon-containing film on at least a portion of a substrate. Examples of suitable substrates include but are not limited to, silicon, SiO₂, Si₃N₄, OSG, FSG, silicon carbide, hydrogenated silicon carbide, silicon nitride, hydrogenated silicon nitride, silicon carbonitride, hydrogenated silicon carbonitride, boronitride, antireflective coatings, photoresists, germanium, germanium-containing, boron-containing, Ga/As, a flexible substrate, organic polymers, porous organic and inorganic materials, metals such as copper and aluminum, and diffusion barrier layers such as but not limited to TiN, Ti(C)N, TaN, Ta(C)N, Ta, W, or WN. The films are compatible with a variety of subsequent processing steps such as, for example, chemical mechanical planarization (CMP) and anisotropic etching processes.

The deposited films have applications which include, but are not limited to, computer chips, optical devices, magnetic information storage devices, coatings on a supporting material or substrate, microelectromechanical systems (MEMS), nanoelectromechanical systems, thin film transistors (TFT), light emitting diodes (LED), organic light emitting diodes (OLED), IGZO, and liquid crystal displays (LCD). Potential uses of the resulting solid silicon oxide or carbon doped silicon oxide include, but are not limited to, shallow trench insulation, inter layer dielectrics, passivation layers, etch stop layers, parts of dual spacers, and sacrificial layers for patterning.

The methods described herein preferably provide a high quality silicon oxide or carbon-doped silicon oxide film. The term "high quality" means a film that exhibits one or more of the following characteristics: a density of about 2.1 g/cc or greater; a wet etch rate that is less than <2.5 Å/s as measured in a solution of 1:100 dilute HF (dHF) acid; an electrical leakage of about 1 or less e-8 A/cm² up to 6 MV/cm; a hydrogen impurity of about 5 e20 at/cc or less as measured by SIMS. With regard to the etch rate, a thermally grown silicon oxide film has 0.5 Å/s etch rate in 1:100 dHF.

In certain embodiments, one or more silicon precursors described herein can be used to form silicon oxide films that are solid and are non-porous or that are substantially free of pores.

The following examples illustrate the method for depositing silicon oxide films described herein and are not intended to limit it in any way.

### EXAM PLES

Unless stated otherwise, in the examples below all plasma enhanced ALD (PEALD) depositions were performed on a commercial style lateral flow reactor (300 mm PEALD tool manufactured by ASM International) equipped with 27.1 MHz direct plasma capability with 3.5 millimeters (mm) fixed spacing between electrodes. The design utilizes outer and inner chambers which have independent pressure settings. The inner chamber is the deposition reactor in which all reactant gases (e.g. silicon precursor, Ar) are mixed in the manifold and delivered to the process reactor. Argon (Ar) gas is used to maintain reactor pressure in the outer chamber. All precursors were liquids maintained at room temperature in stainless steel bubblers and delivered to the chamber with Ar carrier gas, typically set at 200 standard cubic centimeters per minute (sccm) flow. Precursor bubblers were weighed after the first one or two runs and the consumption was about 1.6-2.1 grams (g) per run or about 0.01 moles (mol) per run.

All depositions reported in this study were done on native oxide containing silicon (Si) substrates of 8-12 Ohm-cm. A Rudolph FOCUS Ellipsometer FE-IVD (Rotating Compensator Ellipsometer) was used to measure film thickness and refractive index (RI).

The % thickness non-uniformity quoted was calculated from the formula: ((maximum thickness - mininum thickness)/2*mean thickness))*100. All density measurements were performed with X-ray reflectivity (XRR). XRR was performed on all samples using low-resolution optics. All samples were scanned over the range 0.200 ≤ 2θ ≤ 0.650° using a step size of 0.001° and a count time of 1 second/step. Data were analyzed using a single layer or multi-layer model with the substrate defined as Si. The mass densities of the silicon oxide layers were calculated using SiO₂ as the chemical composition. AFM was performed using a Digital Instruments Dimension 3000 interfaced to a Nanoscope IIIa controller. All measurements were obtained in tapping mode (0.6 - 0.75 Hz scan rate) with single cantilever etched silicon SPM probes (Bruker, NCHV). The scan area used was 2.5 µm x 2.5 µm. Topographic images were captured to understand differences in surface morphology and to calculate surface roughness.

Wet etch rate (WER) was performed using 1% solution of 49% hydrofluoric (HF) acid in deionized water. Thermal oxide wafers were used as reference for each batch to confirm solution concentration. Typical thermal oxide wafer wet etch rate for 1:99 dHF water solution is 0.5 Å/s. Film thickness before and after etch was used to calculate wet etch rate. Conformality study was done on the silicon oxide films was deposited at 100 °C on patterned silicon wafers using a silicon carrier wafer. The film deposited on the substrate was measured using field emission scanning electron microscopy (FESEM) Hitachi SU 8010 FESEM. The samples were mounted in cross-sectional holders and examined using SEM operated at 2 kV accelerating voltage. The silicon oxide thickness measurements of sample cross-sections were taken at the top, the side wall, and the bottom of the trench.

### Example 1. Synthesis of Bis(sec-butylamino)methylsilane

A solution of dichloromethylsilane (110 g, 0.956 mol) in hexanes (200 mL) was added drop wise over 1 hour via addition funnel to a stirred solution of sec-butylamine (308 g, 4.21 mol) in hexanes (1.5 L). The resulting white slurry was warmed to room temperature and allowed to stir overnight. The solids were removed by vacuum filtration over a glass frit and washed twice with hexanes. The combined filtrates were distilled at 1 atmospheres (atm) to remove most of the solvent and excess amine. The crude product was then purified by vacuum distillation (92°C/30torr (4 kPa)) to obtain 111 g of bis(sec-butylamino)methylsilane (b.p. = 192°C; gas chromatography-mass spectroscopy (GC-MS) peaks: 188 (M+), 173 (M-15), 159, 143, 129, 114, 100, 86, 72). About 2.0g of bis(sec-butylamino)methylsilane was loaded into each of 3 stainless steel tubes inside a nitrogen glove box. The tubes were sealed and placed in an oven at 60°C for 4 days. Samples were analyzed to show an assay drop of 0.046%, demonstrating that bis(sec-butylamino)methylsilane is stable and can be potentially used as precursor for commercial vapor deposition processes.

### Example 2. Synthesis of Bis(iso-propylamino)methylsilane.

A solution of dichloromethylsilane (109 g, 0.948 mol) in hexanes (200 mL) was added dropwise over 1 hour via addition funnel to a stirred solution of iso-propylamine (243 g, 4.11 mol) in hexanes (1.5 L). The resulting white slurry was warmed to room temperature and allowed to stir overnight. The solids were removed by vacuum filtration over a glass frit and washed twice with hexanes. The combined filtrates were distilled at 1 atm to remove most of the solvent and excess amine. The crude product was then purified by vacuum distillation (70°C/53torr (7 kPa)) to yield 93 g of bis(iso-propylamino)methylsilane (b.p. = 150°C; GC-MS peaks: 160 (M+), 145 (M-15), 129, 117, 100, 86, 72). About 1.5g of bis(iso-propylamino)methylsilane was loaded in each of 2 stainless steel tubes inside a nitrogen glovebox. The tubes were sealed and placed in an oven at 80°C for 3 days. Samples were analyzed to show assay dropped about 0.14%, which demonstrated that bis(iso-propylamino)methylsilane is stable and can be potentially used as precursor for commercial vapor deposition processes.

### Example 3. Synthesis of Bis(diethylamino)methylsilane.

A solution of dichloromethylsilane (100 g, 0.869 mol) in hexanes (200 mL) was added dropwise over 1 hour via addition funnel to a stirred solution of diethylamine (280 g, 3.83 mol) in hexanes (1.5 L). The resulting white slurry was warmed to room temperature and allowed to stir overnight. The solids were removed by vacuum filtration over a glass frit and washed twice with hexanes. The combined filtrates were distilled at 1 atm to remove most of the solvent and excess amine. The crude product was then purified by vacuum distillation (78°C/16torr (2 kPa)) to yield 103 g of bis(diethylamino)methylsilane (b.p. = 189 °C; GC-MS peaks: 188 (M+), 173 (M-15), 159, 145, 129, 116, 102, 87, 72).

### Comparative Example 4: PEALD Silicon Oxide Using Bis(diethylamino)silane (BDEAS)

Depositions were done with BDEAS as Si precursor (which does not have any Si-Me groups) and O₂ plasma under the parameters provided in Table 6. BDEAS was delivered into the reactor by an Argon (Ar) carrier gas.

**Table 6. PEALD Parameters for Silicon Oxide Using BDEAS**

| Step | | |
|---|---|---|
| a | Introduce Si wafer to the reactor | Deposition temperature = 100°C |
| b | Introduce Si precursor, argon and oxygen to the reactor | Precursor pulse = variable |
| | | Argon flow = 300 sccm |
| | | Oxygen flow = 100 sccm |
| | | Reactor pressure = 3 Torr (400 Pa) |
| c | Purge Si precursor with inert gas (argon) and oxygen | Argon flow = 300 sccm |
| | | Oxygen flow = 100 sccm |
| | | Argon flow time = 2 seconds |
| | | Reactor pressure = 3 Torr (400 Pa) |
| d | Oxidation using oxygen plasma | Argon flow = 300 sccm |
| | | Oxygen flow = 100 sccm |
| | | Plasma power = 200 W |
| | | Plasma time = 2 seconds |
| | | Reactor pressure = 3 Torr (400 Pa) |
| e | Purge oxygen plasma | Plasma off |
| | | Argon flow = 300 sccm |
| | | Argon flow time = 2 seconds |
| | | Reactor pressure = 3 Torr (400 Pa) |

Steps b to e were repeated 500 times to get a desired thickness of silicon oxide films for metrology. Growth per cycle was 1.25 Å/cycle for BDEAS for a precursor pulse of 1 second. Film refractive index (RI) was 1.46. No deposition was observed using the same process conditions but without oxygen plasma, demonstrating that there is no reaction between absorbed precursors and oxygen.

### Example 5 (not according to the invention): PEALD Silicon Oxide Using Dimethylaminotrimethylsilane (DMATMS)

The silicon-containing precursor dimethylaminotrimethylsilane (DMATMS) was delivered into a reactor by vapor draw at ambient temperature (25°C). The vessel is equipped with an orifice with diameter of 0.005" (0.1 mm) to limit precursor flow. The process parameters are similar to that in Table 6 except that the Si precursor pulse ranged from 0.4 to 4 seconds. Film growth rate was measured to be around 0.8 Å/cycle for different precursor pulse time (ranging from 0.5 to 4 seconds), confirming self-limiting ALD growth behavior. This example shows that viable films are produced by PEALD with DMATMS precursor. DMATMS has lower boiling point and higher vapor pressure than BDEAS, making it easier to deliver.

Example 6 (not according to the invention): PEALD Silicon Oxide Using Dimethylaminotrimethylsilane (DMATMS) under High Plasma Power The silicon-containing precursor dimethylaminotrimethylsilane (DMATMS) was delivered by vapor draw at ambient temperature (25°C). The vessel is equipped with orifice with diameter of 0.005" (0.1 mm) to limit precursor flow. Table 7 provides the deposition steps and process parameters.

**Table 7. PEALD Parameters for Silicon Oxide Using DMATMS**

| Step | | |
|---|---|---|
| A | Introduce Si wafer to the reactor | Deposition temperature = 100°C |
| B | Introduce Si precursor to the reactor | Precursor pulse = 2 seconds |
| | | Argon flow = 200 sccm |
| | | Reactor pressure = 2.5 Torr (300 Pa) |
| C | Purge Si precursor with inert gas (argon) | Argon flow = 200 sccm |
| | | Argon flow time = 4 seconds |
| | | Reactor pressure = 2.5 Torr (300 Pa) |
| D | Oxidation using plasma | Argon flow = 200 sccm |
| | | Oxygen flow = 100 sccm |
| | | Plasma power = 800 W |
| | | Plasma time = 8 seconds |
| | | Reactor pressure = 2.5 Torr (300 Pa) |
| E | Purge O₂ plasma | Plasma off |
| | | Argon flow = 200 sccm |
| | | Argon flow time = 2 seconds |
| | | Reactor pressure = 2.5 Torr (300 Pa) |

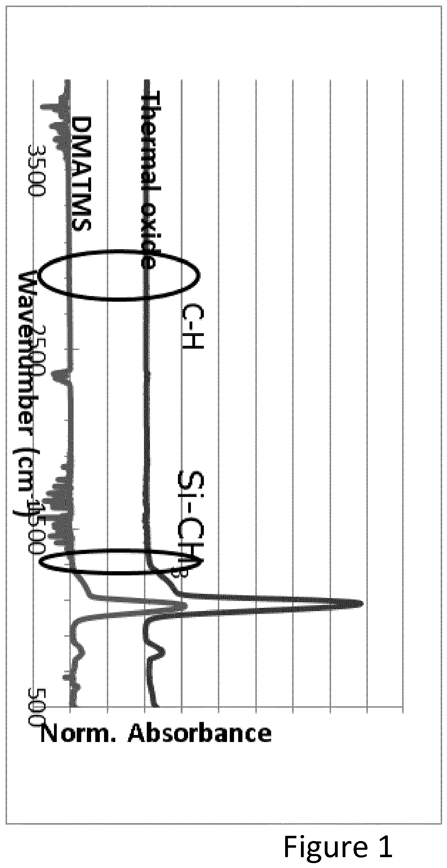

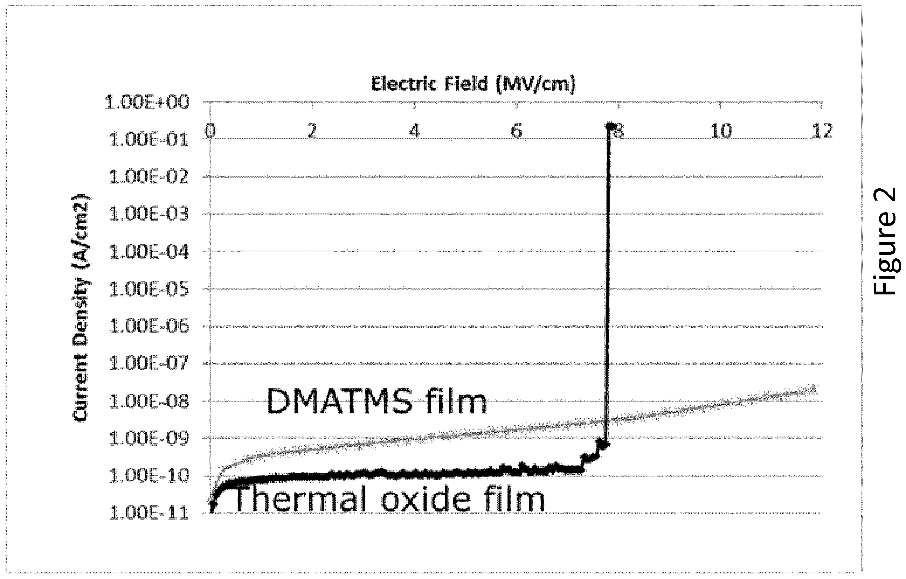

The resulting film properties are provided in Table 8. Refractive index (RI) and thickness for the deposited film were measured using ellipsometry. Film structure and composition were analyzed using FTIR and XPS while density was measured with X-ray reflectivity (XRR). As Table 8 illustrates, a high quality silicon oxide film was obtained. A low WER was obtained (The WER of thermal SiO₂ is 0.43 Å/s under similar conditions). Figures 1 and 2 provide the FTIR spectrum and leakage characteristics, respectively, of the film deposited in Example 6.

**Table 8. Film Properties of Silicon Oxide Film deposited using DMATMS**

| Property | Value |
|---|---|
| XRR Density (g/cc) | 2.2 |
| Composition by XPS | Stoichiometric (66 at. % O, 34 at. % Si) |
| Impurities by XPS (C, N) | ND |
| WER (1% HF) | < 1 Å/s |

Example 7 (not according to the invention): PEALD of Silicon Oxide Film Using Dimethylaminotrimethylsilane (DMATMS) using longer plasma pulse time The process parameters are similar to those provided in Table 7 with a Si precursor pulse of 5 seconds and plasma power ranging from 425 to 800W and plasma time of 8 seconds. All deposited films had high density and low WER; low surface roughness (at instrument noise level) and low SIMS impurity content. The film deposited at room temperature showed a slightly higher SIMS carbon content. Growth per cycle (GPC) was about 0.8 Å/cycle for all these films. The GPC did not change when the experiment was repeated with a 2 s precursor pulse instead of 5 s precursor pulse in Step b.

Table 9A summarizes resulting silicon oxide film properties and Table 9B summarizes the SIMS results.

**Table 9A. Film properties of Silicon Oxide Using DMATMS**

| Dep T (°C) | Power (W) | GPC (Å/cycle) | Density (g/cc) | RMS roughness (nm) | XPS O at. % | XPS Si at.% | WER (Å/s) |
|---|---|---|---|---|---|---|---|
| 25 | 800 | 0.87 | 2.25 | 0.1 | 65.4 | 34.6 | 1.17 |
| 63 | 425 | 0.79 | 2.25 | 0.1 | 64.9 | 35.1 | 1.26 |
| 100 | 800 | 0.80 | 2.27 | 0.1 | 64.7 | 35.3 | 1.07 |

**Table 9B. Composition of Silicon Oxide Using DMATMS**

| DepT (°C) | Power (W) | SIMS H (at/cc) | SIMS C (at/cc) | SIMS N (at/cc) |
|---|---|---|---|---|
| 25 | 800 | 2.08E+20 | 2.92E+20 | 5.20E+18 |
| 63 | 425 | 4.05E+20 | 1.08E+19 | 2.41E+19 |
| 100 | 800 | 1.96E+20 | 1.41E+19 | 9.15E+18 |

### Comparative Example 8: Deposition of silicon oxide films using BDEAS precursor.

A series of silicon oxide films were deposited with the BDEAS precursor using the process steps provided in Table 10 and a continuous oxidant flow of 100 sccm. Table 11 provided the 4 different PEALD processes. Process Nos. 1 and 2 are the process of record (POR) recipe provided in Table 10, with a substrate at room temperature (e.g., ~25°C) and at 100 °C, respectively. Process Nos. 3 and 4 are variations of the POR recipe but conducted at a substrate temperature of 100 °C using different precursor pulse times and plasma powers. The resulting films were characterized to find their thickness, growth per cycle, non-uniformity (%), refractive index, wet etch rate (WER), and root mean square surface roughness (RMS) in nanometers as measured using a AFM instrument. The characterization results of the 4 depositions are summarized in Table 12.

Referring to Table 12, the BDEAS deposited films had good GPC (> 1 Å/cycle), excellent uniformity (< 1 % non-uniformity), good density (> 2.1 g/cc), and low RMS roughness (at AFM instrument detection limit of 0.2 nm). The films are suitable for low temperature high quality oxide applications.

**Table 10. Deposition steps for the process of record (POR) recipe used for comparison of the three precursors**

| Step | | |
|---|---|---|
| a | Introduce Si wafer to the reactor | |
| b | Introduce Si precursor, argon and oxygen to the reactor | Precursor pulse = 1 second |
| | | Argon flow = 300 sccm |
| | | Oxygen flow = 100 sccm |
| | | Reactor pressure = 3 Torr (400 Pa) |
| c | Purge Si precursor with inert gas (argon) and oxygen | Argon flow = 300 sccm |
| | | Oxygen flow = 100 sccm |
| | | Argon flow time = 1 seconds |
| | | Reactor pressure = 3 Torr (400 Pa) |
| d | Oxidation using oxygen plasma | Argon flow = 300 sccm |
| | | Oxygen flow = 100 sccm |
| | | Plasma power = 200 W |
| | | Plasma time = 2 seconds |
| | | Reactor pressure = 3 Torr (400 Pa) |
| e | Purge O₂ plasma | Plasma off |
| | | Argon flow = 300 sccm |
| | | Argon flow time = 1 seconds |
| | | Reactor pressure = 3 Torr (400 Pa) |

**Table 11. Process of Record (POR) Deposition Conditions**

| Process No. | Deposition Temp. (°C) | Precursor Pulse Time (s) | Plasma Power (W) |
|---|---|---|---|
| 1 | 25 | 1 | 200 |
| 2 | 100 | 1 | 200 |
| 3 | 100 | 0.5 | 200 |
| 4 | 100 | 1 | 100 |

**Table 12. Results of BDEAS depositions**

| Process No. | Thickness (Å) | GPC (Å/cycle) | NU (%) | RI (@632 nm) | Density (g/cc) | WER (relative) | AFM roughness (nm) |
|---|---|---|---|---|---|---|---|
| 1 | 1148 | 1.53 | 0.79 | 1.463 | 2.20 | 5.8 | 0.2 |
| 2 | 983 | 1.31 | 0.88 | 1.470 | 2.20 | 4.7 | 0.2 |
| 3 | 948 | 1.26 | 0.82 | 1.470 | N/A | N/A | N/A |
| 4 | 1077 | 1.44 | 0.49 | 1.463 | 2.18 | 7.58 | 0.2 |

### Example 9 (not according to the invention): PEALD of Silicon Oxide Film Using Bis(diethylamino)methylsilane (BDEAMS)

A series of SiO₂ films were deposited with BDEAMS precursor. The process of record (POR) recipe steps that were used to deposit the SiO₂ films are listed in Table 11. The recipe used a continuous oxidant flow of 100 sccm. Like in Table 12, four different PEALD processes were conducted. The results of the 4 depositions are summarized in Table 13. Films obtained had good GPC ≥ 1 Å/cycle), and good uniformity (< 2 % non-uniformity). The films are suitable for low temperature high quality oxide applications.

**Table 13. Results of BDEAMS depositions**

| Process | Thickness (Å) | GPC (Å/cycle) | NU (%) | RI (@632 nm) | WER in dHF (relative) |
|---|---|---|---|---|---|
| 1 | 947 | 1.26 | 0.78 | 1.465 | 5.9 |
| 2 | 809 | 1.08 | 1.34 | 1.468 | 4.9 |
| 3 | 747 | 1.00 | 1.40 | 1.469 | N/A |
| 4 | 868 | 1.16 | 0.73 | 1.452 | 9.53 |

### Example 10: PEALD Silicon Oxide Using Bis(sec-butylamino)methylsilane (BSMAMS)

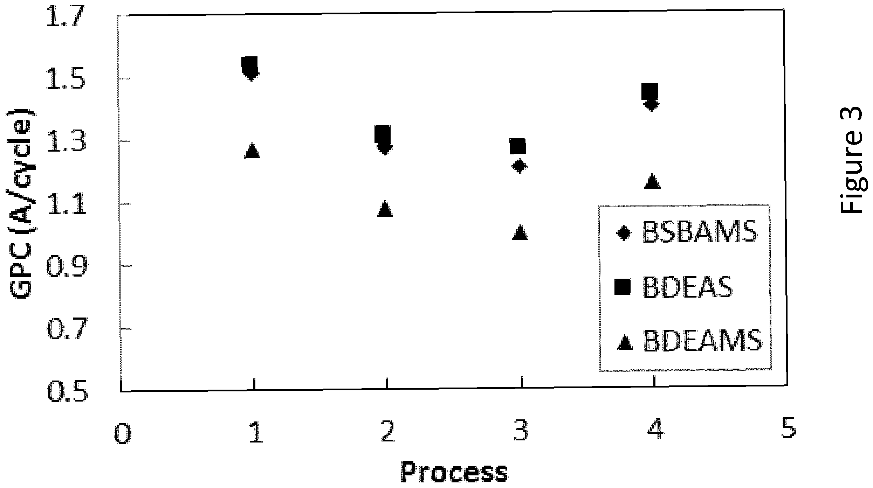

A series of silicon oxide films were deposited with BSBAMS precursor. The process of record (POR) recipe steps that were used to deposit the silicon oxide films are listed in Table 11. As in Table 12, four different PEALD processes were conducted. The results of the four depositions are summarized in Table 14. Films obtained had good GPC (> 1 Å/cycle), excellent uniformity (< 1 % non-uniformity), good density (> 2.1 g/cc), and low RMS roughness (at AFM instrument detection limit of 0.2 nm). The films are suitable for low temperature high quality oxide applications. As shown in Figure 3, BSBAMS having two N-H groups has much higher GPC than BDEAMS under all process conditions, suggesting that primary amino is more reactive than secondary amino for silicon precursors in which the silicon atom has similar environments, i.e. two Si-N bonds, one Si-Me bond and one Si-H bond.

**Table 14. Results of BSBAMS depositions**

| Process | Thickness (Å) | GPC (Å/cycle) | NU (%) | RI (@632 nm) | Density (g/cc) | WER (relative) | AFM roughness (nm) |
|---|---|---|---|---|---|---|---|
| 1 | 1132 | 1.51 | 0.77 | 1.460 | 2.29 | 6.0 | 0.2 |
| 2 | 953 | 1.27 | 0.79 | 1.470 | 2.19 | 4.6 | 0.2 |
| 3 | 905 | 1.21 | 0.81 | 1.463 | N/A | N/A | N/A |
| 4 | 1050 | 1.40 | 0.78 | 1.453 | 2.16 | 7.64 | 0.2 |

### Comparative Example 11: PEALD of Silicon Oxide Film Using Bis(diethylamino)silane (BDEAS)

Silicon oxide films were deposited on a blanket Si coupon and a patterned Si coupon with BDEAS precursor using Process 2 of Table 12. The BDEAS films obtained had good GPC (1.31 Å/cycle). Conformality of the film was very good with thickness measurements of 121, 127 and 127 nm along the top, sidewall and bottom respectively on a 1:20 aspect ratio structure.

### Example 12: Step Coverage of PEALD Silicon Oxide Using Bis(sec-butylamino)methylsilane (BSBAMS)

Silicon oxide films were deposited on a blanket Si coupon and a patterned Si coupon with BSBAMS precursor using Process 2 of Table 12. The BSBAMS films obtained had good GPC (1.27 Å/cycle). Conformality of the film was very good with thickness measurements of 119, 123 and 111 nm along the top, sidewall and bottom respectively on a 1:20 aspect ratio structure.

## Claims

1. A method to deposit a film comprising silicon and oxide onto a substrate comprising steps of:
a) providing a substrate in a reactor;
b) introducing into the reactor at least one silicon precursor selected from the group consisting of bis(sec-butylamino)methylsilane, bis(isobutylamino)methylsilane, bis(cyclohexylamino)methylsilaneand combinations thereof;
c) purging the reactor with purge gas;
d) introducing an oxygen-containing source into the reactor; and
e) purging the reactor with purge gas; and
wherein steps b through e are repeated until a desired thickness of film is deposited; and
wherein the method is conducted at one or more temperatures in the range of 25°C to 300°C.

2. The method of claim 1, wherein the method is selected from plasma enhanced atomic layer deposition (PEALD), plasma enhanced cyclic chemical vapor deposition (PECCVD), a plasma-enhanced ALD-like process or an ALD process.

3. The method of any one of the preceding claims, wherein the oxygen-containing source comprises ozone, water, oxygen, NO, N₂O, NO₂, carbon monoxide (CO), carbon dioxide (CO₂) or a combination thereof.

4. The method of any one of the preceding claims wherein the oxygen-containing source comprises plasma and optionally further comprises an inert gas.

5. The method of any one of the preceding claims, wherein the oxygen-containing source is selected from the group consisting of an oxygen plasma, a plasma comprising oxygen and argon, a plasma comprising oxygen and helium, an ozone plasma, a water plasma, a nitrous oxide plasma, a carbon dioxide plasma, and combinations thereof.

6. The method of claim 4 or claim 5 wherein the plasma is generated in situ or is generated remotely.

7. The method of any one of the preceding claims wherein at least one purge gas is selected from nitrogen, helium and argon, neon, hydrogen and mixtures thereof.

8. The method of claim any one of the preceding claims wherein the density of the film is 2.1g/cc or greater.

9. The method of any one of the preceding claims wherein the film further comprises carbon, and wherein optionally wherein the carbon content of the film is 0.5 atomic percent (at.%) or greater as measured by x-ray photospectroscopy.

10. The method of claim 9, wherein the density of the film is 1.8g/cc or greater.

11. A method as claimed in any one of the preceding claims to deposit a film selected from a silicon oxide film and a carbon doped silicon oxide film onto a substrate.

12. A composition for depositing a film selected from a silicon oxide or a carbon doped silicon oxide film using a vapor deposition process, the composition comprising: a compound selected from the group consisting of bis(sec-butylamino)methylsilane, bis(isobutylamino)methylsilane, bis(cyclohexylamino)methylsilaneand combinations thereof.

13. A composition as claimed in claim 12, wherein the compound is selected from bis(sec-butylamino)methylsilane, and bis(cyclohexylamino)methylsilane.

## Patentansprüche

1. Verfahren zum Abscheiden eines Silizium und Oxid umfassenden Films auf einem Substrat, umfassend die folgenden Schritte:
a) Bereitstellen eines Substrats in einem Reaktor;
b) Einleiten mindestens eines Siliziumvorläufers in den Reaktor, ausgewählt aus der Gruppe bestehend aus Bis(sec-butylamino)methylsilan, Bis(isobutylamino)methylsilan, Bis(cyclohexylamino)methylsilan und Kombinationen davon;
c) Spülen des Reaktors mit Spülgas;
d) Einleiten einer sauerstoffhaltigen Quelle in den Reaktor; und
e) Spülen des Reaktors mit Spülgas; und
wobei die Schritte b bis e wiederholt werden, bis eine gewünschte Dicke des Films abgeschieden ist; und
wobei das Verfahren bei einer oder mehreren Temperaturen im Bereich von 25 °C - 300 °C durchgeführt wird.

2. Verfahren nach Anspruch 1, wobei das Verfahren ausgewählt ist aus plasmaunterstützter Atomschichtabscheidung (PEALD), plasmaunterstützter zyklischer chemischer Dampfabscheidung (PECCVD), einem plasmaunterstützten ALD-ähnlichen Prozess oder einem ALD-Prozess.

3. Verfahren nach einem der vorhergehenden Ansprüche, wobei die sauerstoffhaltige Quelle Ozon, Wasser, Sauerstoff, NO, N₂O, NO₂, Kohlenmonoxid (CO), Kohlendioxid (CO₂) oder eine Kombination davon umfasst.

4. Verfahren nach einem der vorhergehenden Ansprüche, bei dem die sauerstoffhaltige Quelle ein Plasma und gegebenenfalls zusätzlich ein Inertgas umfasst.

5. Verfahren nach einem der vorhergehenden Ansprüche, wobei die sauerstoffhaltige Quelle ausgewählt ist aus der Gruppe bestehend aus einem Sauerstoffplasma, einem Plasma, das Sauerstoff und Argon enthält, einem Plasma, das Sauerstoff und Helium enthält, einem Ozonplasma, einem Wasserplasma, einem Lachgasplasma, einem Kohlendioxidplasma und Kombinationen davon.

6. Verfahren nach Anspruch 4 oder 5, wobei das Plasma an Ort und Stelle oder aus der Ferne erzeugt wird.

7. Verfahren nach einem der vorhergehenden Ansprüche, bei dem mindestens ein Spülgas ausgewählt ist aus Stickstoff, Helium und Argon, Neon, Wasserstoff und deren Mischungen.

8. Verfahren nach einem der vorhergehenden Ansprüche, bei dem die Dichte des Films 2,1 g/cm³ oder mehr beträgt.

9. Verfahren nach einem der vorhergehenden Ansprüche, wobei der Film weiterhin Kohlenstoff enthält und wobei gegebenenfalls der Kohlenstoffgehalt des Films 0,5 Atomprozent (at.%) oder mehr beträgt, gemessen durch Röntgenphotospektroskopie.

10. Verfahren nach Anspruch 9, wobei die Dichte des Films 1,8 g/cm³ oder größer ist.

11. Verfahren nach einem der vorhergehenden Ansprüche zum Abscheiden eines Films, ausgewählt aus einem Siliziumoxidfilm und einem kohlenstoffdotierten Siliziumoxidfilm, auf ein Substrat.

12. Zusammensetzung zum Abscheiden eines Films, ausgewählt aus einem Siliciumoxid- oder einem kohlenstoffdotierten Siliciumoxidfilm, unter Verwendung eines Dampfabscheidungsverfahrens, wobei die Zusammensetzung umfasst: eine Verbindung, ausgewählt aus der Gruppe, bestehend aus Bis(sec-butylamino)methylsilan, Bis(isobutylamino)methylsilan, Bis(cyclohexylamino)methylsilan und Kombinationen davon.

13. Zusammensetzung nach Anspruch 12, wobei die Verbindung aus Bis(sec-butylamino)methylsilan und Bis(cyclohexylamino)methylsilan ausgewählt ist.

## Revendications

1. Procédé pour déposer un film comprenant du silicium et de l'oxyde sur un substrat comprenant les étapes de :
a) fourniture d'un substrat dans un réacteur ;
b) introduction dans le réacteur d'au moins un précurseur de silicium choisi dans le groupe consistant en bis(sec-butylamino)méthylsilane, bis(isobutylamino)méthylsilane, bis(cyclohexylamino)méthylsilane et leurs combinaisons ;
c) purge du réacteur avec un gaz de purge ;
d) introduction d'une source contenant de l'oxygène dans le réacteur ; et
e) purge du réacteur avec un gaz de purge ; et
dans lequel les étapes b à e sont répétées jusqu'à ce qu'une épaisseur souhaitée de film soit déposée ; et
le procédé étant réalisé à une ou plusieurs températures dans la plage de 25°C à 300°C.

2. Procédé selon la revendication 1, le procédé étant choisi parmi un dépôt chimique en phase vapeur assisté par plasma (PEALD), un dépôt chimique en phase vapeur cyclique assisté par plasma (PECCVD), un procédé du type ALD assisté par plasma ou un procédé ALD.

3. Procédé selon l'une quelconque des revendications précédentes, dans lequel la source contenant de l'oxygène comprend de l'ozone, de l'eau, de l'oxygène, du NO, du N₂O, du NO₂, du monoxyde de carbone (CO), du dioxyde de carbone (CO₂) ou une de leurs combinaisons.

4. Procédé selon l'une quelconque des revendications précédentes, dans lequel la source contenant de l'oxygène comprend du plasma et comprend facultativement en outre un gaz inerte.

5. Procédé selon l'une quelconque des revendications précédentes, dans lequel la source contenant de l'oxygène est choisie dans le groupe consistant en plasma d'oxygène, plasma comprenant de l'oxygène et de l'argon, plasma comprenant de l'oxygène et de l'hélium, plasma d'ozone, plasma d'eau, plasma d'oxyde de diazote, plasma de dioxyde de carbone, et leurs combinaisons.

6. Procédé selon la revendication 4 ou la revendication 5, dans lequel le plasma est généré in situ ou est généré à distance.

7. Procédé selon l'une quelconque des revendications précédentes, dans lequel au moins un gaz de purge est choisi parmi l'azote, l'hélium et l'argon, le néon, l'hydrogène et leurs mélanges.

8. Procédé selon l'une quelconque des revendications précédentes, dans lequel la densité du film est supérieure ou égale à 2,1 g/cc.

9. Procédé selon l'une quelconque des revendications précédentes, dans lequel le film comprend en outre du carbone, et facultativement dans lequel la teneur en carbone du film est supérieure ou égale à 0,5 pour cent atomique (% atomique), telle que mesurée par photospectroscopie à rayons X.

10. Procédé selon la revendication 9, dans lequel la densité du film est supérieure ou égale à 1,8 g/cc.

11. Procédé selon l'une quelconque des revendications précédentes pour déposer un film choisi parmi un film d'oxyde de silicium et un film d'oxyde de silicium dopé au carbone sur un substrat.

12. Composition pour déposer un film choisi parmi un film d'oxyde de silicium et un film d'oxyde de silicium dopé au carbone en utilisant un procédé de dépôt en phase vapeur, la composition comprenant : un composé choisi dans le groupe consistant en bis(sec-butylamino)méthylsilane, bis(isobutylamino)méthylsilane, bis(cyclohexylamino)méthylsilane et leurs combinaisons.

13. Composition selon la revendication 12, dans laquelle le composé est choisi parmi le bis(sec-butylamino)méthylsilane et le bis(cyclohexylamino)méthylsilane.
